# EUROPÄISCHE PATENTSCHRIFT

(11) **EP 2 556 590 B1**
(45) Veröffentlichungstag und Bekanntmachung des Hinweises auf die Patenterteilung: **19.08.2015**
(21) Anmeldenummer: 11713974.1
(22) Anmeldetag: 06.04.2011
(51) Int. Cl.: H03K 17/10, H03K 17/567, H03K 17/687

(54) **SCHALTEINRICHTUNG MIT JFET-SERIESCHALTUNG**
SWITCHING DEVICE HAVING A JFET SERIES CIRCUIT
DISPOSITIF DE COMMUTATION AVEC CIRCUIT DE JFET EN SÉRIE

(30) Priorität: 07.04.2010 CH 500102010
(43) Veröffentlichungstag der Anmeldung: 13.02.2013
(73) Patentinhaber: ETH Zurich, 8092 Zürich ETH-Zentrum (CH)
(72) Erfinder: AGGELER, Daniel, CH-8044 Zürich (CH); BIELA, Jürgen, CH-8004 Zürich (CH); KOLAR, Johann, Walter, CH-8044 Zürich (CH)
(74) Vertreter: Frei Patent Attorneys
(86) Internationale Anmeldenummer: PCT/CH2011/000072
(87) Internationale Veröffentlichungsnummer: WO 2011/123962

(56) Entgegenhaltungen:
- EP-A1- 2 394 363
- WO-A1-2010/088783
- DE-A1- 19 926 109
- BIELA J ET AL: "Balancing circuit for a 5kV/50ns pulsed power switch based on SiC-JFET Super Cascode", PULSED POWER CONFERENCE, 2009. PPC '09. IEEE, IEEE, PISCATAWAY, NJ, USA, 28. Juni 2009 (2009-06-28), Seiten 635-640, XP031615057, ISBN: 978-1-4244-4064-1 in der Anmeldung erwähnt

## Beschreibung

Die Erfindung bezieht sich auf das Gebiet der elektronischen Schaltungstechnik und insbesondere auf eine Schalteinrichtung mit einer Serieschaltung von Sperrschicht-FETs (JFET oder Junction Field Effect Transistor) gemäss dem Oberbegriff von Patentanspruch 1 respektive Anspruch 9.

### STAND DER TECHNIK

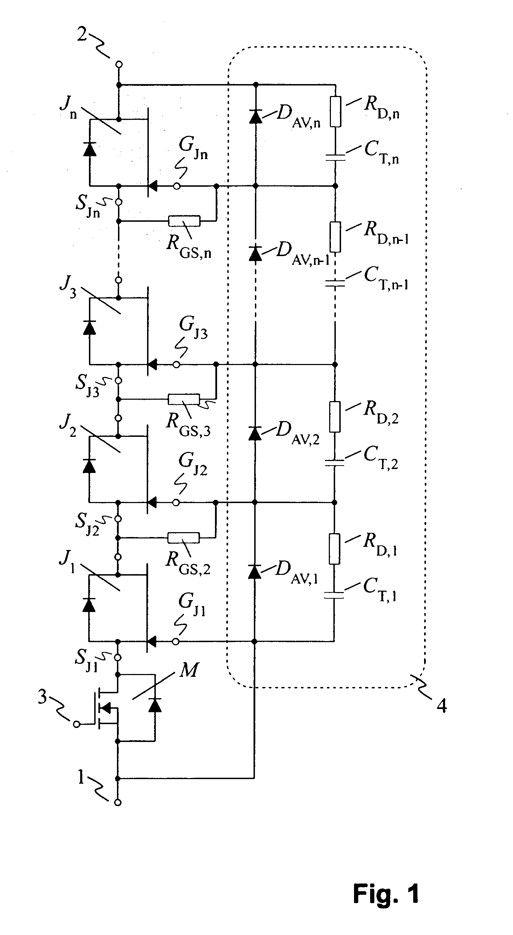

Leistungsschalter oder Schalteinrichtungen zum Schalten bei hohen Betriebsspannungen können in leistungselektronischen Schaltungen durch Kaskadierung oder in Serie angeordnete Transistoren realisiert werden. Dabei werden nach US6,822,842 oder DE 199 26 109 A1 solche Schalteinrichtungen beispielsweise als KaskodeSchaltung bezeichnet, welche auf der speziellen Zusammenschaltung eines MOSFET M und mindestens einem JFET J₁ basieren, illustriert durch die **Figur 1**. Die Schalter sind zwischen einem ersten Anschluss 1 und einem zweiten Anschluss 2 angeordnet und durch einen Steueranschluss 3 des MOSFET M gesteuert. Diese bekannte Schalteinrichtung für hohe Betriebsspannungen basierend auf der Kaskoden-Topologie sieht vor, mehrere JFETs J₂...Jₙ in Serie zu schalten und damit eine hohe Sperrspannung zu erreichen. Zur passiven Steuerung der dynamischen Sperrspannungsaufteilung des mit seriellen angeordneten Transistoren aufgebauten Leistungsschalters wird ein Beschaltungsnetzwerk 4 zwischen dem ersten Anschluss 1 und dem zweiten Anschluss 2 angeschlossen, wobei Avalanche-Dioden D_{AV,l}-D_{AV,n} des Beschaltungsnetzwerkes 4 zwischen den Gate-Anschlüssen der JFETs angeschlossen sind. Die Funktionsweise des Beschaltungsnetzwerkes 4 zur symmetrischen Sperrspannungsaufteilung der JFETs ist in der Publikation "Balancing Circuit for a 5kV/50ns Pulsed Power Switch Based on SiC-JFET Super Cascode" (J. Biela, D. Aggeler, J.W. Kolar, Proceedings of the 17th IEEE Pulsed Power Conference (PPC'09)) beschrieben.

Aufgrund der Durchlasswiderstände der einzelnen Halbleiterschalter M, J₁...Jₙ in der Serieschaltung entsteht im eingeschalteten Zustand ein Spannungsabfall über jedem Element. Dabei bewirkt die Summe aller Spannungsabfälle speziell beim obersten JFET Jₙ der Fig. 1, eine andere Gate-Source Spannung als bei den unteren JFETs. Diese unterschiedliche Gate-Source Spannung kann dazu führen, dass der oberste Transistor ausgeschaltet und dabei hochohmig wird und eine hohe Vorwärtsspannung im eingeschalteten Zustand erfährt, was im schlimmsten Fall zu seiner Zerstörung führt.

DE 199 26 109 A1 offenbart eine Kaskoden-Schaltung mit mehreren JFETs in Serie, wobei zwischen den Gates der JFETs jeweils eine Parallelschaltung von einem Hilfstransistor und einer Zenerdiode vorliegt, welche zur Begrenzung der Spannungen über den JFETs dienen.

Biela J. et al.: "Balancing circuit for a 5 kV/50ns pulsed power switch based on SiC-JFET Super Cascode", Pulsed Power Conference, 2009. PPC '09, IEEE, 28. Juni 2009, Seiten 635-640, beschreibt ebenfalls eine Kaskoden-Schaltung mit mehreren JFETs in Serie, mit einem Beschaltungsnetzwerk entsprechend der Figur 1 zur dynamischen Verteilung der Sperrspannungsaufteilung.

### DARSTELLUNG DER ERFINDUNG

Es ist deshalb die Aufgabe der Erfindung, eine Schalteinrichtung mit einer Serieschaltung von Sperrschicht-FETs der eingangs genannten Art zu schaffen welche die oben genannten Nachteile behebt.

Diese Aufgabe löst eine Schalteinrichtung mit einer Serieschaltung von Sperrschicht-FETs mit den Merkmalen der Patentansprüche 1 oder 5.

Die Schalteinrichtung zum Schalten eines Stromes zwischen einem ersten Anschluss und einem zweiten Anschluss weist also eine Serieschaltung von mindestens zwei JFETs auf, von denen ein unterster JFET mit dem ersten Anschluss verbunden ist oder über einen in Serie angeordneten Steuerschalter mit dem ersten Anschluss verbunden ist. Es liegt mindestens ein weiterer JFET vor, der zu dem untersten JFET in Serie geschaltet ist, wobei der am weitesten vom untersten JFET entfernte JFET als oberster JFET bezeichnet wird und mit seinem Drainanschluss mit dem zweiten Anschluss verbunden ist. Die vom untersten oder ersten JFET verschiedenen JFET werden zusammenfassend auch als obere JFET bezeichnet. Es ist ein Beschaltungsnetzwerk zur dynamischen Sperrspannungsaufteilung und zur Stabilisierung der Gatespannungen der JFETs zwischen dem ersten Anschluss und dem zweiten Anschluss geschaltet. Das Beschaltungsnetzwerk weist beispielsweise jeweils zwischen den Gates zweier aufeinanderfolgender JFETs in Sperrichtung betriebene Dioden auf. Dabei ist jeweils zwischen den Gateanschlüssen der oberen JFETs und der Kathode der jeweiligen Diode eine Zusatzschaltung geschaltet, welche im eingeschalteten Zustand der Schaltung das Potential am Gateanschluss der oberen JFETs hoch hält, und ein unerwünschtes Ausschalten der oberen JFETs verhindert.

Dadurch werden bei eingeschalteten oberen JFETs abhängig vom Laststrom die Spannungen an den oberen Gates geringfügig über, vorzugsweise aber gleich bzw. geringfügig unter der Spannung am jeweiligen Sourceanschluss gehalten. Vorzugsweise resultiert eine Gate-Sourcespannung, welche mindestens zweimal, vorzugsweise fünfmal oder zehnmal kleiner ist als ohne die Zusatzschaltung. Dadurch bleiben beim Einschalten die oberen JFETs eher eingeschaltet als ohne die Zusatzschaltung. Dadurch wiederum wird verhindert, dass insbesondere der oberste JFET zwischen dem ersten und dem zweiten Anschluss hochohmig wird und die gesamte Spannung aufnimmt.

Die in den unabhängigen Ansprüchen definierte Zusatzschaltung bewirkt, dass beim Einschalten die parasitären Kapazitäten des Beschaltungsnetzwerkes sich jeweils über die Diode der Zusatzschaltung entladen können und gleichzeitig die jeweiligen Gates der JFETs über eine Kapazität parallel zur Diode der Zusatzschaltung hoch gehalten wird.

Dadurch wird die dynamische Einschaltung des mit seriell angeordneten Transistoren aufgebauten Leistungsschalters durch die gesamte Zusatzschaltung balanciert wie auch synchronisiert.

Die Zusatzschaltung für sich alleine gesehen vermag, allgemein gesprochen, für jeden der JFETs eine vorgebbare Spannung zwischen dessen Gateanschluss und Sourceanschluss anzulegen. Diese Zusatzschaltung bewirkt eine symmetrische Spannungsbelastung der Gate Sourceanschlüsse der seriell geschalteten JFETs.

In beispielhaften Ausführrungen ist die Zusatzschaltung nicht bei jedem der oberen JFET angeschlossen, sondern nur bei einem oder mehreren, vorzugsweise bei weiter oben liegenden JFETs.

In einer weiteren Ausführungsform der Erfindung wird in mindestens einer der Zusatzschaltungen eine weitere Diode antiparallel zur bestehenden Diode und in Serie zum Kondensator der Zusatzschaltung geschaltet. Diese resultierende Ansteuerschaltung bewirkt, dass sich die Kondensatoren der Zusatzschaltung während des dynamischen Einschaltens und des statischen Einschaltzustandes nicht entladen und somit die Gatepotentiale der oberen JFETs auf einem definierten Potential bleiben.

In einer weiteren Ausführungsform der Erfindung ist die Folge von Diode und Zusatzschaltung in der Serieschaltung umgekehrt: die Zusatzschaltung ist nicht zwischen Gateanschluss und Kathodenanschluss, sondern zwischen Gateanschluss des jeweils unteren JFETs und dem Anodenanschluss der jeweiligen Diode angeschlossen.

Grundsätzlich gilt, dass die Schaltung sinngemäss modifiziert auch für p-Kanal JFETs anstelle der hier gezeichneten n-Kanal JFETs einsetzbar ist. Dabei entspricht komplementär der Drainanschluss dem Sourceanschluss und der Sourceanschluss dem Drainanschluss.

Weitere bevorzugte Ausführungsformen gehen aus den abhängigen Patentansprüchen hervor.

### KURZE BESCHREIBUNG DER ZEICHNUNGEN

Im Folgenden wird der Erfindungsgegenstand anhand von bevorzugten Ausführungsbeispielen, welche in den beiliegenden Zeichnungen dargestellt sind, näher erläutert. Es zeigen jeweils schematisch:
- Figur 1: eine Serieschaltung von Sperrschicht-FETs gemäss dem Stand der Technik; und
- Figur 2: eine erste Ausführungsform der Erfindung, und
- Figur 3: eine zweite Ausführungsform der Erfindung.

Grundsätzlich sind in den Figuren gleiche Teile mit gleichen Bezugszeichen versehen.

### WEGE ZUR AUSFÜHRUNG DER ERFINDUNG

In Figur 1 ist der Stand der Technik für eine Schalteinrichtung hoher Betriebsspannung dargestellt. Die Schaltung weist eine Kaskodenschaltung eines MOSFET M mit einem ersten oder untersten JFET J₁ und mindestens einem in Serie zu diesem ersten JFET J₁ geschalteten weiteren oder oberen JFET J₂-Jₙ auf. Der unterste oder erste JFET ist also in der Kaskodenschaltung von einem als Steuerschalter wirkenden MOSFET angesteuert. Der letzte, am weitesten vom ersten JFET entfernte JFET der in Serie geschalteten JFETs wird auch als oberster JFET Jₙ bezeichnet. Zur Stabilisierung der Gatespannungen der JFETs und zur Vergleichmässigung der Spannungsbelastung der JFETs ist ein Beschaltungsnetzwerk 4 angeordnet. Dieses weist jeweils zwischen den Gates zweier aufeinanderfolgender JFETs eine Parallelschaltung von in Sperrichtung betriebenen Diode D_{AV,1}, D_{AV,2},....D_{AV,n} und einer RC-Schaltung R_{D,1} C_{T,1}, R_{D,2} C_{T,2}, ...R_{D,n} C_{T,n} auf.

Jeweils zwischen Gate und Source der oberen JFETs J₂-Jₙ (also nicht des ersten JFET) sind Widerstände (in Figur 1: R_{GS,2} - R_{GS,n}) geschaltet. Anstelle der Widerstände können auch Zenerdioden verwendet werden.

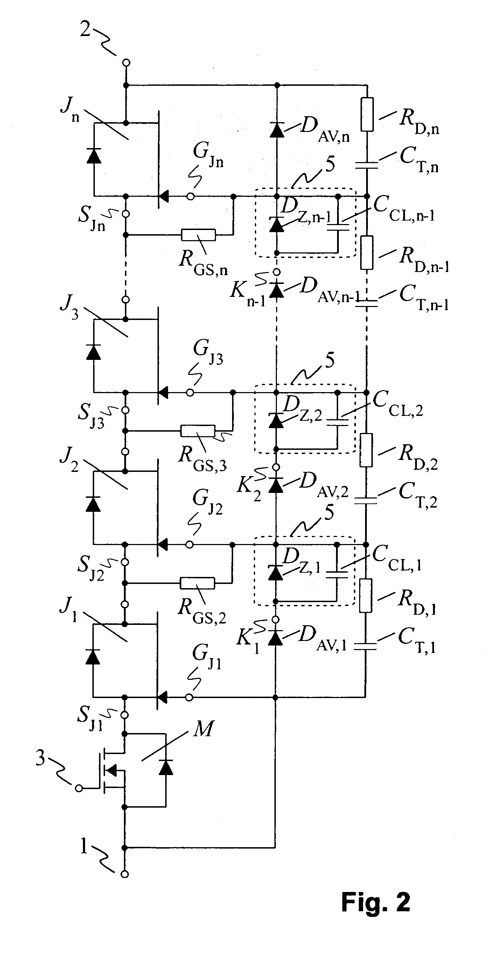

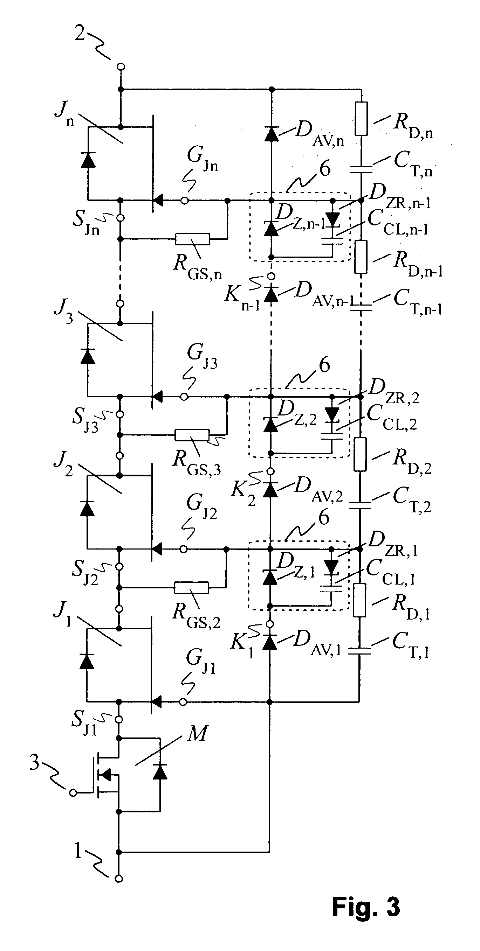

Zur dynamischen und auch statischen Kontrolle der Gatespannungen zwischen dem Gate (G_{J2}, G_{J3}...G_{Jn}) und dem Kathodenanschluss (K₁, K₂...Kₙ₋₁) der Diode des Beschaltungsnetzwerkes ist in den Figuren 2 und 3 jeweils eine Zusatzschaltung 5 geschaltet. Diese weist gemäss der Figur 2 eine Parallelschaltung aus einer Zenerdiode D_{Z,1}, D_{Z,2},...D_{Z,n-1} und eines Kondensators C_{CL,1}, C_{CL,2},...C_{CL,n-1} auf. Diese bewirken, dass das Potential am Gateanschluss der oberen JFETs hochgehalten wird und damit einerseits die Vorwärtsspannung der Dioden, andererseits der Spannungsabfall resultierend wegen dem Durchlasswiderstand kompensiert und die anliegende Spannung zwischen dem Gateanschluss und dem Sourceanschluss vorzugsweise gleich null oder gering positiv gehalten wird.

Der Kondensator der Zusatzschaltung ist, verglichen mit der Sperrschichtkapazität der in Sperrrichtung betriebenen Dioden und der Drain-Sourcekapazität des jeweiligen JFETs, um ein Vielfaches grösser und bewirkt dadurch beim Einschalten, dass die gespeicherte Energie nicht vollständig entzogen werden kann und eine resultierende Spannung über dem Kondensator der Zusatzschaltung verbleibt, welche die Spannung des jeweiligen Gates hochhält.

Das Beschaltungsnetzwerk leitet von den Gateanschlüssen der JFETs (J₁-Jₙ) einen Ladestrom in die jeweils zugeordneten Speicherelemente (Sperrschichtkapazität der in Sperrrichtung betriebenen Diode und Kapazität des RC-Elementes des Beschaltungsnetzwerkes mit der Zusatzschaltung) ab und bewirkt damit eine dynamische Stabilisierung der in Serie geschalteten JFETs.

Anstelle der Zenerdiode und des Kondensators können in der Zusatzschaltung andere Schaltungselemente vorliegen, welche den gleichen Effekt bewirken, z.B. nur eine oder zwei oder mehr in Serie geschaltete Zenerdioden, bzw. nur eine oder zwei oder mehrere parallel geschaltete Kondensatoren.

In einer bevorzugten Ausführungsform der Erfindung ist die Zusatzschaltung nicht bei jedem der oberen JFET angeschlossen, sondern nur bei einem oder mehreren, vorzugsweise bei weiter oben liegenden JFETs.

**Figur 3** zeigt eine alternative bevorzugte Ausführungsform der Erfindung, in welcher weitere Dioden D_{ZR,1}, D_{ZR,2}, ...D_{ZR,n-1} jeweils seriell zum Kondensator und antiparallel zur Diode der Zusatzschaltung geschaltet sind.

Für die Erfindung als Ganzes gilt grundsätzlich, dass die Schaltung, sinngemäss modifiziert auch für p-Kanal JFETs anstelle der hier gezeichneten n-Kanal JFETs, einsetzbar ist.

## Patentansprüche

1. Schalteinrichtung zum Schalten eines Stromes zwischen einem ersten Anschluss (1) und einem zweiten Anschluss (2), aufweisend eine Serieschaltung von mindestens zwei JFETs (J₁-Jₙ),
von denen ein unterster JFET (J₁) mit dem ersten Anschluss (1) verbunden ist oder der unterste JFET (J₁) in einer Kaskodeschaltung über einen Steuerschalter (M) mit dem ersten Anschluss (1) verbunden ist,
und einem oder mehreren weiteren, oberen JFET (J₂-Jₙ), der oder die zu dem untersten JFET (J₁) in Serie geschaltet ist/sind, wobei der am weitesten vom untersten JFET (J₁) entfernte JFET (Jₙ) als oberster JFET (Jₙ) bezeichnet wird und mit seinem Drainanschluss mit dem zweiten Anschluss (2) verbunden ist, und
wobei ein passives Beschaltungsnetzwerk (4) zur dynamischen Ansteuerung der Gatespannungen der JFETs (J₁-Jₙ) zwischen Gateanschlüsse der JFETs (J₁-Jₙ) und dem ersten Anschluss (1) geschaltet ist,
wobei das Beschaltungsnetzwerk (4) jeweils zwischen den Gates zweier JFETs der Serieschaltung von JFETs (J₁-Jₙ), wobei der Drainanschluss eines ersten der zwei JFETs mit dem Sourceanschluss des zweiten der zwei JFETs verbunden ist, erste Dioden (D_{AV,1}, D_{AV,2},....D_{AV,n}) aufweist,
**dadurch gekennzeichnet, dass** zwischen den Gateanschlüssen (G_{J2}, G_{J3},...G_{Jn}) der oberen JFETs (J₂, J₃,...,Jₙ) und Kathodenanschlüssen (K₁, K₂, K₃,...Kₙ₋₁) der ersten
Dioden des Beschaltungsnetzwerks (4), oder zwischen Anodenanschlüssen der ersten
Dioden des Beschaltungsnetzwerks (4) und den Gateanschlüssen (G_{J1}, G_{J2}, G_{J3},...G_{Jn-1}) von zugeordneten JFETs (J₁, J₃,...,Jₙ₋₁), jeweils eine Zusatzschaltung (5) geschaltet ist,
wobei die Zusatzschaltung (5) eine oder mehrere in Serie betriebene zweite Dioden (D_{Z,1}, D_{Z,2},...D_{Z,n-1}) aufweist, welche in Serie zu den ersten Dioden (D_{AV,1}, D_{AV,2},....D_{AV,n}) geschaltet sind, und jeweils entweder
• eine Anode einer der **ersten** Dioden mit dem Gate verbunden ist, welches näher zum **untersten** JFET liegt und die Kathode einer der **zweiten** Dioden mit dem Gate verbunden ist, welches näher zum **obersten** JFET liegt, oder
• eine Anode einer der **zweiten** Dioden mit dem Gate verbunden ist, welches näher zum **untersten** JFET liegt und die Kathode einer der **ersten** Dioden mit dem Gate verbunden ist, welches näher zum **obersten** JFET liegt, wobei
die Zusatzschaltung (5) einen oder mehrere jeweils parallel zu den zweiten
Dioden (D_{Z,1}, D_{Z,2},...D_{Z,n-1}) geschaltete Kondensatoren (C_{CL,1}, C_{CL,2},...C_{CL,n-1}) aufweist.

2. Schalteinrichtung gemäss Anspruch 1, wobei die zweiten Dioden (D_{Z,1}, D_{Z2},...D_{Zn-1}) zwischen den Gateanschlüssen (G_{J2}, G_{J3}, ...,G_{Jn}) und den Kathodenanschlüssen (K₁, K₂, ...,Kₙ₋₁) geschaltet sind.

3. Schalteinrichtung gemäss Anspruch 1 oder 2, wobei mindestens eine Ansteuerschaltung (6) aus einer Zusatzschaltung und einer weiteren Diode (D_{ZR,1}, D_{ZR,2},...,D_{ZR,n-1}) vorliegt.

4. Schalteinrichtung gemäss Anspruch 3, in welcher in mindestens einer der Zusatzschaltungen (6) eine weitere Diode (D_{ZR,1}, D_{ZR,2},...,D_{ZR,n-1}) in Serie zum Kondensator der Zusatzschaltung und antiparallel zur zweiten Diode (D_{Z,1}, D_{Z,2},...D_{Z,n-1}) der Zusatzschaltung geschaltet ist.

5. Schalteinrichtung zum Schalten eines Stromes zwischen einem ersten Anschluss und einem zweiten Anschluss, aufweisend eine Serieschaltung von mindestens zwei p-Kanal JFETs,
von denen ein unterster JFET mit dem ersten Anschluss verbunden ist oder der unterste JFET in einer Kaskodeschaltung über einen Steuerschalter mit dem ersten Anschluss verbunden ist,
und einem oder mehreren weiteren, oberen JFET, der oder die zu dem untersten JFET in Serie geschaltet ist/sind, wobei der am weitesten vom untersten JFET entfernte JFET als oberster JFET bezeichnet wird und mit seinem Sourceanschluss mit dem zweiten Anschluss verbunden ist, und
wobei ein passives Beschaltungsnetzwerk zur dynamischen Ansteuerung der Gatespannungen der JFETs zwischen Gateanschlüsse der JFETs und dem ersten Anschluss geschaltet ist,
wobei das Beschaltungsnetzwerk jeweils zwischen den Gates zweier JFETs der Serieschaltung von JFETs (J₁-Jₙ), wobei der **Sourceanschluss** eines ersten der zwei JFETs mit dem **Drainanschluss** des zweiten der zwei JFETs verbunden ist, erste Dioden aufweist,
**dadurch gekennzeichnet, dass** zwischen den Gateanschlüssen der oberen JFETs und Kathodenanschlüssen der ersten Dioden des Beschaltungsnetzwerks, oder zwischen Anodenanschlüssen der ersten Dioden des Beschaltungsnetzwerks und den Gateanschlüssen von zugeordneten JFETs, jeweils eine Zusatzschaltung geschaltet ist,
wobei die Zusatzschaltung eine oder mehrere in Serie betriebene zweite Dioden aufweist, welche in Serie zu den ersten Dioden geschaltet sind, und jeweils entweder
• eine Anode einer der **ersten** Dioden mit dem Gate verbunden ist, welches näher zum **untersten** JFET liegt und die Kathode einer der **zweiten** Dioden mit dem Gate verbunden ist, welches näher zum **obersten** JFET liegt, oder
• eine Anode einer der **zweiten** Dioden mit dem Gate verbunden ist, welches näher zum **untersten** JFET liegt und die Kathode einer der **ersten** Dioden mit dem Gate verbunden ist, welches näher zum **obersten** JFET liegt, wobei
die Zusatzschaltung einen oder mehrere jeweils parallel zu den zweiten Dioden geschaltete Kondensatoren aufweist.

## Claims

1. A switching device for switching a current between a first terminal (1) and a second terminal (2), comprising a series arrangement of at least two JFETs (J₁-Jₙ),
of which a lowermost JFET (J₁) is connected to the first terminal (1), or the lowermost JFET (J₁) is connected in a cascode arrangement via a control switch (M) to the first terminal (1),
and of one or more further, upper JFETs (J₂-J₅) which is or are connected in series to the lowermost JFET (J₁), wherein the JFET (Jₙ) which is distanced furthest from the lowermost JEFT (J₁) is indicated as the uppermost JFET (Jₙ) and with its drain terminal is connected to the second terminal (2), and
wherein a passive circuit network (4) for the dynamic activation or the gate voltages of the JFETs (J₁-Jₙ) is connected between the gate terminals or the JEFTs (J₁-Jₙ) and the first terminal (1),
wherein the circuit network (4) comprises first diodes (D_{AV,1}, D_{AV,2}, ... D_{AV,n}) in each case between the gates of two JFETs of the series arrangement of JFETs (J₁-Jₙ), wherein the drain terminal of a first one of the two JEFTs is connected to the source terminal of the second of the two JFETs,
**characterised in that** an additional circuit (5) is connected in each case between the gate terminal (G_{J2}, G_{J3} ... G_{Jn}) of the upper JFETs (J₂, J₃,..., Jₙ) and the cathode terminals (K₁, K₂, K₃, ... Kₙ₋₁) of the first diodes of the circuit network (4), or between anode terminals of the first diodes of the circuit network (4) and the gate terminals (G_{J1}, G_{J2}, G_{J3} ... G_{Jn}) of assigned JFETs (J₁, J₃,...., Jₙ₋₁),
wherein the additional circuit (5) comprises one or more second diodes (D_{Z,1}, D_{Z,2} ... D_{Z,n-1}) which are operated in series and which are connected in series to the first diodes (D_{AV,1}, D_{AV,2},... D_{AV,n}), and in each case either
• an anode of one of the **first** diodes is connected to the gate which lies closer to the **lowermost JFET,** and the cathode of one of the **second** diodes is connected to the gate which lies closer to the **uppermost** JFET, or
• an anode of one of the **second** diodes is connected to the gate which lies closer to the **lowermost** JFET, and the cathode of one of the first diodes is connected to the gate which lies closer to the **uppermost** JFET, wherein
wherein the additional circuit (5) comprises one or more capacitors (C_{CL,1}, C_{CL,2} ... C_{CL, n-1}) which each are connected parallel to the second diodes (D_{Z,1}, D_{Z2}... D_{Z,n-1}).

2. A switching device according to claim 1, wherein the second diodes (D_{Z, 1}, D_{Z,2} ... D_{Z,n-1}) are connected between the gate terminals (G_{J2}, G_{J3} ... G_{Jn}) and the cathode terminals (K₁, K₂, ...Kₙ₋₁).

3. A switching device according to claim 1 or 2, wherein at least one activation circuit (6) made of an additional circuit and of a further diode (D_{ZR, 1}, D_{ZR,2}... D_{ZR,n-1}) is present.

4. A switching device according to claim 3, in which in at least one of the additional circuits (6), a further diode (D_{ZR,1}, D_{ZR,2} ... D_{ZR,n-1}) is connected in series to the capacitor of the additional circuit and antiparallel to the second diode (D_{Z,1},·D_{Z,2} ... D_{Z,n-1}) of the additional circuit.

5. A switching device for switching a current between a first terminal and a second terminal, comprising a series arrangement of at least two p-channel JFETs,
of which a lowermost JFET is connected to the first terminal, or the lowermost JFET is connected in a cascode arrangement via a control switch to the first terminal,
and of one or more further, upper JFETs which is or are connected in series to the lowermost JFET, wherein the JFET which is distanced furthest from the lowermost JEFT is indicated as the uppermost JFET and with its source terminal is connected to the second terminal and
wherein a passive circuit network for the dynamic activation of the gate voltages of the JFETs is connected between the gate terminals of the JEFTs and the first terminal,
wherein the circuit network comprises first diodes in each case between the gates of two JFETs of the series arrangement of JFETs, wherein the **source terminal** of a first one of the two JEFTs is connected to the **drain terminal** of the second of the two JFETs,
**characterised in that** an additional circuit is connected in each case between the gate terminals of the upper JFETs and the cathode terminals of the first diodes of the circuit network, or between anode terminals of the first diodes of the circuit network and the gate terminals of assigned JFETs,
wherein the additional circuit comprises one or more second diodes which are operated in series and which arc connected in series to the first diodes, and in each case either
• an anode of one of the **first** diodes is connected to the gate which lies closer to the **lowermost** JFET, and the cathode of one of the **second** diodes is connected to the gate which lies closer to the **uppermost** JFET, or
• an anode of one of the **second** diodes is connected to the gate which lies closer to the **lowermost** JFET, and the cathode of one of the **first** diodes is connected to the gate which lies closer to the **uppermost** JFET, wherein
the additional circuit (5) comprises one or more capacitors which each arc connected parallel to the second diodes.

## Revendications

1. Circuit de commutation d'un courant entre une première borne de raccordement (1) et une deuxième borne de raccordement (2), avec un circuit série constitué d'au moins deux JFET (J₁-Jₙ),
parmi lesquels un JFFT inférieur (J₁) est raccordé à la première borne de raccordement (1) ou le JFET inférieur (J₁) est raccordé à la première borne de raccordement (1) dans un circuit cascode par l'intermédiaire d'un commutateur de puissance (M) et
un ou plusieurs autres JFFT supérieurs (J₂-Jₙ) qui sont raccordés en série au JFET inférieur (J₁), le JFET (Jₙ) le plus éloigné du JFET, inférieur (J₁) étant appelé JFET supérieur (Jₙ) et étant raccordé à la deuxième borne de raccordement (2) par sa borne de drain,
un réseau passif de commutation (4) permettant la commande dynamique des tensions de grille des JFET (J₁-Jₙ) étant raccordé entre les bornes de grille des JFET (J₁-Jₙ) et la première borne de raccordement (1),
le réseau de commutation (4) présentant des premières diodes (D_{AV, 1}, D_{AV, 2}, ..., D_{AV, n}) entre les grilles de deux JFET du circuit série de JFET (J₁-Jₙ), la borne de drain d'un premier des deux JFET étant raccordée à la borne de source du deuxième des deux JFET, **caractérisé en ce que**
un circuit supplémentaire (5) est raccordé entre les bornes de grille (G_{J2}, G_{J3}, ..., G_{Jn}) des JFET supérieurs
(J₂, J₃, ..., Jₙ) et les bornes de cathode (K₁, K₂, K₃ ..., Kₙ₋₁) des premières diodes du réseau de commutation (4) ou entre les bornes d'anode des premières diodes du réseau de commutation (4) et les bornes de grille (G_{J2}, G_{J3}, ..., G_{Jn}) de JFET (J₁, J₃, ..., Jₙ₋₁) associés,
**en ce que** le circuit supplémentaire (5) présente une ou plusieurs deuxièmes diodes (D_{Z, 1}, D_{Z, 2}, ..., D_{Z, n-1}) utilisées en série et raccordées en série aux premières diodes (D_{AV,1}, D_{AV,2}, ..., D_{AV, n}), et
**en ce que** l'anode de l'une des premières diodes est raccordée à la grille située le plus près du JFET inférieur et la cathode de l'une des deuxièmes diodes est raccordée à la grille située le plus près du JFET supérieur ou
**en ce que** l'anode de l'une des deuxièmes diodes est raccordée à la grille située le plus près du JFET inférieur et la cathode de l'une des premières diodes est raccordée à la grille la plus proche du JFET supérieur et
**en ce que** le circuit série (5) présente un ou plusieurs condensateurs (C_{CL, 1}, C_{CL, 2}, ..., C_{CL, n-1}) raccordés en parallèle aux deuxièmes diodes (D_{Z, 1}, D_{Z, 2}, ..., D_{Z,n-1}).

2. Circuit selon la revendication 1, dans lequel les deuxièmes diodes (D_{Z, 1}, D_{Z, 2}, ..., D_{Z, n-1}) sont raccordées entre les bornes de grille (G_{J2}, G_{J3}, ..., G_{Jn}) et les bornes de cathode (K₁, K₂, ..., Kₙ₋₁).

3. Circuit selon les revendications 1 ou 2, dans lequel au moins un circuit de commande (6) constitué d'un circuit supplémentaire et d'une deuxième diode (D_{ZR, 1}, D_{ZR, 2}, ..., D_{ZR, n-1}) est prévu.

4. Circuit selon la revendication 3, dans lequel dans au moins l'un des circuits supplémentaires (6), une autre diode (D_{ZR, 1}, D_{ZR, 2}, ..., D_{ZR, n-1}) est raccordée en série sur le condensateur du circuit supplémentaire et de manière antiparallèle par rapport à la deuxième diode (D_{Z, 1}, D_{Z, 2}, ..., D_{Z, n-1}).

5. Circuit de commutation d'un courant entre une première borne de raccordement et une deuxième borne de raccordement, avec un circuit série constitué d'au moins deux JFET à canal p,
parmi lesquels un JFET inférieur est raccordé à la première borne de raccordement ou le JFET inférieur est raccordé à la première borne de raccordement dans un circuit cascode par l'intermédiaire d'un commutateur de puissance et
un ou plusieurs autres JFET supérieurs qui sont raccordés en série au JFET inférieur, le JFET le plus éloigné du JFET inférieur étant appelé JFET supérieur et étant raccordé à la deuxième borne de raccordement par sa borne de source,
un réseau passif de commutation permettant la commande dynamique des tensions de grille des JFET étant raccordé entre les bornes de grille des JFET et la première borne de raccordement,
le réseau de commutation présentant des premières diodes entre les grilles de deux JFET du circuit série de JFET, la borne de source d'un premier des deux JFET étant raccordée à la borne de drain du deuxième des deux JFET, **caractérisé en ce que**
un circuit supplémentaire est raccordé entre les bornes de grille des JFET supérieurs et les bornes de cathode des premières diodes du réseau de commutation ou entre les bornes d'anode des premières diodes du réseau de commutation et les bornes de grille de JFET associés,
**en ce que** le circuit supplémentaire présente une ou plusieurs deuxièmes diodes raccordées en série aux premières diodes,
**en ce que** l'anode de l'une des premières diodes est raccordée à la grille située le plus près du JFET inférieur et la cathode de l'une des deuxièmes diodes est raccordée à la grille située le plus près du JFET supérieur ou
**en ce que** l'anode de l'une des deuxièmes diodes est raccordée à la grille située le plus près du JFET inférieur et la cathode de l'une des premières diodes est raccordée à la grille la plus proche du JFET supérieur et
**en ce que** le circuit série présente un ou plusieurs condensateurs raccordés en parallèle aux deuxièmes diodes.
